(19) Europäisches Patentamt
European Patent Office
Office européen des brevets

(11) **EP 4 492 681 A1**

(12) **EUROPEAN PATENT APPLICATION**

(43) Date of publication:
**15.01.2025 Bulletin 2025/03**

(21) Application number: **24185769.7**

(22) Date of filing: **01.07.2024**

(51) International Patent Classification (IPC):
**H03F 1/22** $^{(2006.01)}$      **H03F 3/45** $^{(2006.01)}$

(52) Cooperative Patent Classification (CPC):
**H03F 3/45183; H03F 1/223; H03F 3/45192;
H03F 3/45197;** H03F 2200/375; H03F 2200/498;
H03F 2203/45038; H03F 2203/45152;
H03F 2203/45182; H03F 2203/45244;
H03F 2203/45258; H03F 2203/45291;
H03F 2203/45298; H03F 2203/45322;
H03F 2203/45354;      (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.07.2023 US 202318352034**

(71) Applicant: **STMicroelectronics International N.V.
1228 Plan-les-Ouates, Geneva (CH)**

(72) Inventor: **MICHAL, Vratislav
38120 Fontanil-Cornillon (FR)**

(74) Representative: **Casalonga
Casalonga & Partners
Bayerstraße 71/73
80335 München (DE)**

(54) **CIRCUIT FOR VOLTAGE OFFSET COMPENSATION**

(57) A circuit includes a current source, a differential pair of transistors coupled to the current source, an active load, and a current injection circuit. The differential pair of transistors has a first offset voltage and an input transconductance. The current injection circuit is configured to supply a first current and a second current to produce a second offset voltage across the differential pair of transistors opposite the first offset voltage. The first current and the second current has a same thermal dependence as the input transconductance of the differential pair of transistors.

FIG. 5

EP 4 492 681 A1

(52) Cooperative Patent Classification (CPC): (Cont.)
H03F 2203/45392; H03F 2203/45452;
H03F 2203/45471; H03F 2203/45482;
H03F 2203/45496; H03F 2203/45648;
H03F 2203/45681

**Description**

**TECHNICAL FIELD**

The present invention relates generally to electronic circuits, and, in particular embodiments, to circuits for voltage offset compensation.

**BACKGROUND**

Analog comparators and operational amplifiers are important elements in CMOS analog circuit design. However, the accuracy of related analog functions may be limited by the input-referred offset voltage, $V_{OS}$, between input voltages $V_{IN+}$ and $V_{IN-}$. This offset voltage occurs in analog comparator and operational amplifier circuits due to device mismatch. For example, random offset voltage arises from device mismatch due to process variations in a supposedly identical pair of devices, such as transistors in differential pairs (also referred to as long-tailed pairs) or current mirrors in active loads. Traditional source-coupled differential pairs used in such devices may typically achieve an input offset voltage $V_{OS}$ within a range of $\pm$ 5 mV. To attain desired circuit performance, offset compensation (also referred to as voltage offset trimming or trimming) may be employed to reduce the offset voltage $V_{OS}$.

Main contributors to device mismatch producing the offset voltage $V_{OS}$ are the parameters associated with the first-order MOS transistor saturated drain current Eq. (1):

$$I_D = \frac{1}{2}\mu_x C_{ox}\frac{W}{L}(V_{GS} - |V_{TH}|)^2 = \frac{\beta}{2}\frac{W}{L}(V_{GS} - |V_{TH}|)^2 \qquad (1)$$

namely threshold voltage $V_{TH}$ and gain factor $\beta = \mu_{n,p}C_{ox}(W/L)$. The gain factor $\beta$ depends on the electron/hole mobility $\mu_{n,p}$, gate oxide capacitance per unit area $C_{ox}$, and channel aspect ratio $W/L$. In saturation, the gate source voltage, $V_{GS}$, can be expressed from Eq. (1) as the sum of threshold voltage $V_{TH}$ and overdrive voltage $V_{OV}$:

$$V_{GS} = V_{TH} + V_{OV} = V_{TH} + \sqrt{\frac{2I_D}{\mu_{n,p}C_{ox}}\frac{L}{W}} \qquad (2)$$

A small change $\Delta V_{GS}$ leads to a corresponding change $\Delta I_D$, which can be determined by evaluating the transconductance, $g_m$, obtained as the derivative of Eq. (1):

$$g_m = \sqrt{2\mu_{n,p}Cox\frac{W}{L}I_D} = \sqrt{2\beta I_D} \qquad (3)$$

Besides the layout quality, matching errors may roughly follow the Pelgrom model, which associates contributions $\sigma(\Delta V_T)$ and $\sigma(\Delta\beta/\beta)$ with transistor effective area $\bm{W \cdot L}$:

$$\sigma(\Delta V_T) = \frac{A_{VT}}{\sqrt{WL}}, \quad \sigma\left(\frac{\Delta\beta}{\beta}\right) = \frac{A_\beta}{\sqrt{WL}} \qquad (4)$$

In this model, $A_{VT}$ and $A_\beta$ are mismatched parameters. Improving matching by increasing differential pair area may result in severe increase of parasitic capacitance and silicon area. Compared to this, offset reduction by circuit design allows for preservation of reasonable area efficiency and the frequency characteristic of the operational amplifier or comparator.

**SUMMARY**

In accordance with an embodiment, a circuit includes: a current source; a differential pair of transistors coupled to the current source, the differential pair of transistors having a first offset voltage and an input transconductance; an active load, the active load being coupled to respective drains of the differential pair of transistors opposite the current source; and a current injection circuit, the current injection circuit being coupled to the respective drains of the differential pair of transistors, the current injection circuit being configured to supply a first current and a second current to the respective drains, the first current and the second current producing a second offset voltage across the differential pair of transistors opposite the first offset voltage, the first current and the second current having a same thermal dependence as the input transconductance of the differential pair of transistors.

In accordance with another embodiment, a circuit includes: a current source, the current source being coupled to a supply voltage node; a differential pair of transistors coupled to the current source opposite the supply voltage node, the differential pair of transistors having a first offset voltage and an input transconductance, the input transconductance having a thermal dependence; an active load, the active load being coupled to the differential pair of transistors opposite the current source, the active load including a first current mirror, each transistor of the first current mirror being coupled to the supply voltage node across a respective source resistance, each transistor of the first current mirror being further coupled to respective unipolar current sources, where the respective unipolar current sources are configured to produce a first current and a second current; and a current injection circuit, the current injection circuit being coupled to respective nodes between drains of the differential pair of transistors and the active load, the current injection circuit being configured to supply a first current and a second current to the respective nodes between the drains of the differential pair of transistors and the active load, the first current and the second current producing a second offset voltage across the differential pair of transistors opposite the first offset voltage, the first current and the second current having a same thermal dependence as the input transconductance of the differential pair of transistors.

In accordance with yet another embodiment, a circuit includes: a differential pair, the differential pair including a first transistor and a second transistor, the first transistor and the second transistor being coupled through a first resistance; a first programmable current source coupled to a first node between the first transistor and the first resistance; a second programmable current source coupled to a second node between the second transistor and the first resistance; and a first bias current source coupled to the differential pair.

It is to be understood that both the foregoing general description and the following detailed description are exemplary and explanatory only and are not restrictive of the disclosure, as claimed.

## BRIEF DESCRIPTION OF THE DRAWINGS

For a more complete understanding of the present invention, and the advantages thereof, reference is now made to the following descriptions taken in conjunction with the accompanying drawings, in which:

Figure 1 illustrates a schematic of an example operational transconductance amplifier;

Figure 2 illustrates a schematic of another example operational transconductance amplifier;

Figure 3 illustrates a schematic of yet another example operational transconductance amplifier;

Figures 4 and 5 illustrate schematics of circuits including temperature compensated programmable current injection, in accordance with some embodiments;

Figures 6 and 7 illustrate schematics of circuits including current mirror circuits with current injection, in accordance with some embodiments;

Figures 8, 9, 10, and 11 illustrate schematics of circuits including tail offset voltage trimming, in accordance with some embodiments;

Figure 12 illustrates a schematic of a circuit for offset voltage, in accordance with some embodiments; and

Figure 13 illustrates a schematic of an operational transconductance amplifier configured for trimming through temperature-compensated current injections, in accordance with some embodiments.

Corresponding numerals and symbols in the different figures generally refer to corresponding parts unless otherwise indicated. The figures are drawn to clearly illustrate the relevant aspects of the embodiments and are not necessarily drawn to scale. The edges of features drawn in the figures do not necessarily indicate the termination of the extent of the feature.

## DETAILED DESCRIPTION OF ILLUSTRATIVE EMBODIMENTS

The making and using of various embodiments are discussed in detail below. It should be appreciated, however, that the various embodiments described herein are applicable in a wide variety of specific contexts. The specific embodiments discussed are merely illustrative of specific ways to make and use various embodiments, and should not be construed in a limited scope. The particular embodiments are merely illustrative of specific configurations and do not limit the scope of the claimed embodiments. Features from different embodiments may be combined to form further embodiments unless noted otherwise.

Variations or modifications described in one of the embodiments may also apply to others. Further, various changes, substitutions, and alterations can be made herein without departing from the spirit and scope of this disclosure as defined by the appended claims.

According to one or more embodiments of the present disclosure, this application relates to circuits and methods of operation providing voltage offset compensation while also reducing the temperature dependence of the compensated offset voltage. Disclosed embodiments of circuits and methods may be useful for significantly reducing temperature drift while reducing the voltage offset. Temperature compensated current injection for offset voltage trimming may be performed between differential pairs and active loads. Active load current mirrors may be used to apply temperature compensated voltage offsets. Tail voltage generation circuits may provide offset voltage trimming with temperature stability. Offset voltage may also be provided behind a gate of a differential pair transistor. Temperature stability of transconductance ratios between current mirrors and differential pairs may be improved by selectively applying temperature transconductance damping to either the PMOS or NMOS transistors using selected resistances. This can improve residual temperature stability of trimmed and untrimmed offset voltage.

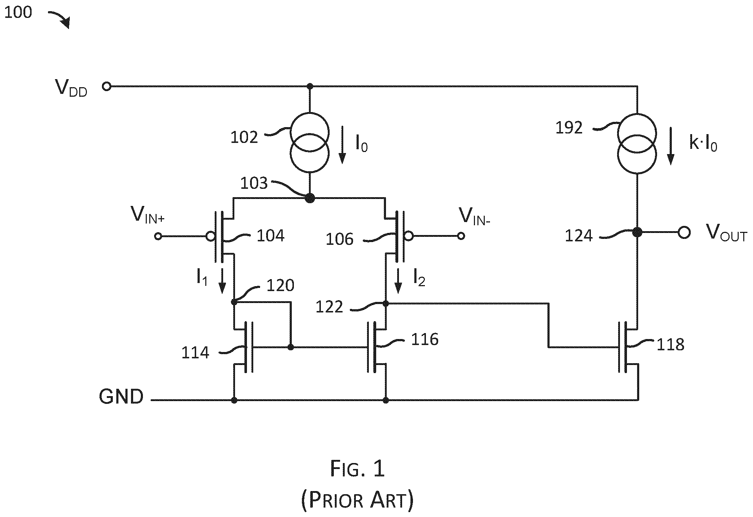

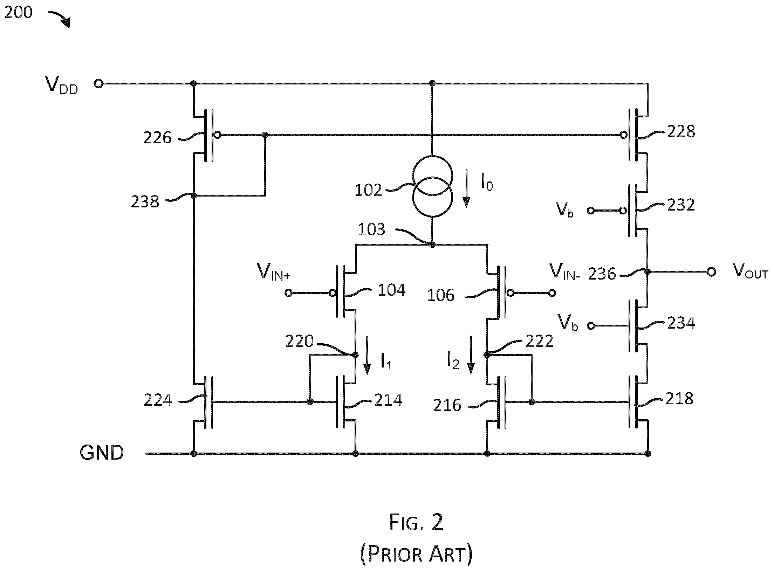

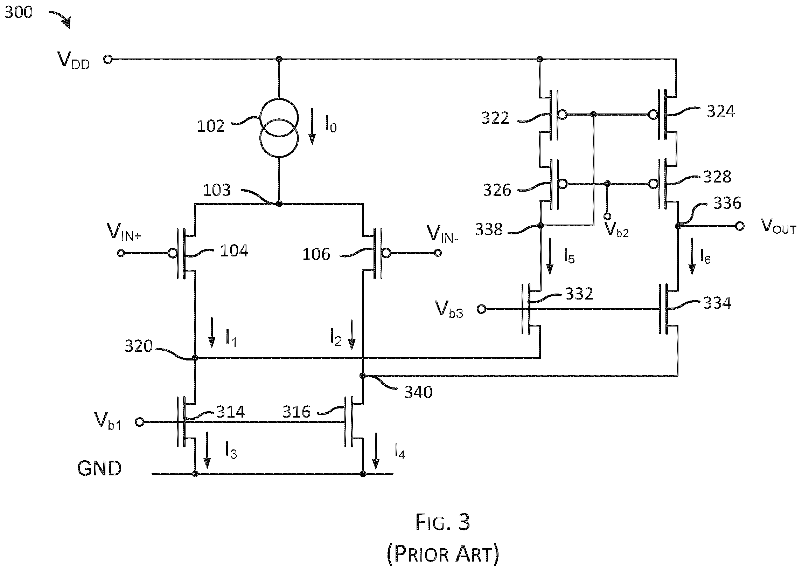

Figures 1-3 illustrate schematics of example operational transconductance amplifiers (OTAs) with PMOS differential pairs. Figure 1 illustrates a schematic of a Miller OTA with two gain stages, Figure 2 illustrates a schematic of a single gain stage symmetrical OTA, and Figure 3 illustrates a folded cascode OTA with a single gain stage. Disclosed embodiments of systems and methods for voltage offset compensation may be applied to any of the OTAs illustrated by Figures 1-3, as well as to any other suitable OTAs or other circuits. In some widely used operational transconductance amplifiers (OTAs) illustrated by Figures 1-3, which form the base of the majority of operational amplifiers and comparators, an input offset voltage Vas is primarily caused by a mismatch in a differential pair of transistors accepting input voltages or in an active load comprising one or more current mirrors.

Figure 1 illustrates a schematic of an example of a PMOS differential pair Miller operational transconductance amplifier (OTA) 100 with two gain stages. The Miller OTA 100 accepts two input voltages through a differential pair of transistors and outputs a signal that is the difference of the input voltages boosted by the gains of the two gain stages.

A bias current source 102 is coupled to a supply voltage node providing a supply voltage $V_{DD}$ and to a node 103. In some examples, the bias current source 102 is a transistor (e.g., a PMOS or NMOS device) coupled to a bias voltage at its gate. However, any suitable current source may be used for the bias current source 102. The bias current source 102 may be coupled to the supply voltage node at supply voltage $V_{DD}$ at its source terminal and to the node 103 at its drain terminal. The bias current source 102 may also be coupled to the supply voltage node at its drain terminal and to the node 103 at its source terminal. The source terminal and drain terminal of CMOS transistors may also be referred to interchangeably as source/drain terminals or as terminals.

Transistors 104 and 106 form a differential pair (also referred to as a long-tailed pair). Transistors 104 and 106 are also referred to as input transistors. Terminals of the transistors 104 and 106 are coupled to node 103, which receives a bias current $I_0$ from the bias current source 102 and is at a tail voltage $V_{TAIL}$. Terminals provided with respective input voltages $V_{IN+}$ and $V_{IN-}$ are coupled to the gates of the transistors 104 and 106, respectively. In some examples, the transistors 104 and 106 of the differential pair are PMOS devices. However, any suitable transistors, such as NMOS devices or the like, may be used to form the differential pair.

An active load is formed by transistors 114 and 116. In some examples, the transistors 114 and 16 are NMOS devices. However, any suitable transistors, such as PMOS devices or the like, may be used to form the active load. A terminal of transistor 114 is coupled through a node 120 to a terminal of transistor 104 opposite the node 103, and a terminal of transistor 116 is coupled through a node 122 to a terminal of transistor 106 opposite the node 103. A current $I_1$ flows from the transistor 104 to the node 120, and a current $I_2$ flows from the transistor 106 to the node 122. Respective terminals of transistors 114 and 116 opposite the differential pair are coupled to a ground node. Respective gates of transistors 114 and 116 are coupled to each other and to node 122.

A current source 192 is coupled between the supply voltage node and a terminal of an output transistor 118 through a node 124. The current source 192 may provide a current $k \cdot I_o$, where k is a suitable constant such as 0.5. In some examples, the output transistor 118 is an NMOS device. However, any suitable transistor may be used. The current source 192 provides a current $k \cdot I_0$ to the node 124. The opposite terminal of the output transistor 118 is coupled to a ground node, and the gate of the output transistor 118 is coupled to node 122. An output voltage node provided with an output voltage $V_{OUT}$ is coupled to the node 124.

Figure 2 illustrates a schematic of an example single gain stage symmetrical OTA 200. The single gain stage symmetrical OTA 200 accepts two input voltages through a differential pair of transistors and outputs a voltage that is the difference of the input voltages amplified by the gain of the OTA. Current mirrors are utilized to establish symmetrical operation.

A bias current source 102 is coupled to a supply voltage node providing a supply voltage $V_{DD}$ and to a node 103. Respective terminals of a differential pair of transistors 104 and 106 are coupled to node 103, which receives a bias current $I_o$ from the bias current source 102 and is at a tail voltage $V_{TAIL}$ terminals at respective input voltages $V_{IN+}$ and $V_{IN-}$ are coupled to the gates of the transistors 104 and 106, respectively.

An active load is formed by transistors 214, 216, 218, 224, 226, and 228. In some examples, the transistors 214, 216, 218, and 224 are NMOS devices and the transistors 226 and 228 are PMOS devices. However, any suitable transistors, such as PMOS devices or the like, may be used. A terminal of transistor 214 is coupled through a node 220 to a terminal of transistor 104 opposite the node 103, and a terminal of transistor 216 is coupled through a node 222 to a terminal of transistor 106 opposite the node 103. A current 11 flows from the transistor 104 to the node 220, and a current $I_2$ flows from the transistor 106 to the node 222. Respective terminals of transistors 214 and 216 opposite the differential pair are coupled to a ground node. The gate of transistor 214 is coupled to the gate of transistor 224 and to node 220. The gate of transistor 216 is coupled to the gate of transistor 218 and to node 222.

Terminals of transistor 226 are coupled to the supply voltage node and to node 238, and terminals of transistor 224 are coupled to the ground node and to node 238. The gate of transistor 228 is coupled to node 238 and to the gate of transistor 228. Transistors 228 and 232 are coupled in series between the supply voltage node and node 236. Transistors 232 and 234 form a cascode (and are also referred to as cascode transistors). In some examples, the transistors 232 and 234 are PMOS devices. However, any suitable transistors, such as NMOS devices or the like, may be used. Transistors 234 and 218 are coupled between node 236 and the ground node. Respective gates of the cascode transistors 232 and 234 are coupled to one or more bias voltage node(s) providing a bias voltage $V_b$. An output voltage node provided with an output voltage $V_{OUT}$ is coupled to the node 236.

Figure 3 illustrates a schematic of an example folded cascode OTA 300, also referred to as a folded cascode OTA with a single gain stage. The folded cascode OTA 300 accepts two input voltages through a differential pair of transistors and outputs a signal that is the difference of the input voltages amplified by the gain of OTA. A folded cascode improves the gain and linearity of the OTA.

A bias current source 102 is coupled to a supply voltage node providing a supply voltage $V_{DD}$ and to a node 103. Respective terminals of a differential pair of transistors 104 and 106 are coupled to node 103, which receives a bias current $I_o$ from the bias current source 102 and is at a tail voltage $V_{TAIL}$ terminals at respective input voltages $V_{IN+}$ and $V_{IN-}$ are coupled to the gates of the transistors 104 and 106, respectively.

An active load is formed by transistors 314, 316, 322, and 324. Transistors 314 and 316 form a first current mirror and transistors 322 and 324 form a second current mirror. In some embodiments, the transistors 314 and 316 are NMOS devices and the transistors 322 and 324 are PMOS devices. However, any suitable transistors may be used to form the active load. A terminal of transistor 314 is coupled through a node 320 to a terminal of transistor 104 opposite the node 103, and a terminal of transistor 316 is coupled through a node 340 to a terminal of transistor 106 opposite the node 103. A current $I_1$ flows from the transistor 104 to the node 320, and a current I2 flows from the transistor 106 to the node 340. Respective terminals of transistors 314 and 316 opposite the differential pair are coupled to a ground node. Respective gates of transistors 314 and 316 are coupled to a bias voltage node providing a bias voltage $V_{b1}$. A current $I_3$ flows from the transistor 314 to the ground node, and a current $I_4$ flows from the transistor 316 to the ground node.

A folded cascode comprises transistors 332 and 334 (also referred to as cascode transistors). In some examples, transistors 332 and 334 are NMOS devices. However, any suitable transistors may be used to form the folded cascode.

Transistors 322 and 326 are coupled by their terminals in series between the supply voltage node and node 338, and transistors 324 and 328 are coupled by their terminals in series between the supply voltage node and node 336. The gates of transistors 322 and 324 are coupled to the node 338, and the gates of transistors 326 and 328 are coupled to a bias voltage node providing a bias voltage $V_{b3}$.

Transistor 332 is coupled by its terminals between nodes 320 and 338, and transistor 334 is coupled by its terminals between nodes 340 and 336. A current $I_5$ flows from the node 338 into transistor 332, and a current $I_6$ flows from the node 336 into the transistor 334. The gates of transistors 332 and 334 are coupled to a bias voltage node supplying a bias voltage $V_{b2}$. An output voltage node provided with an output voltage $V_{OUT}$ is coupled to the node 336.

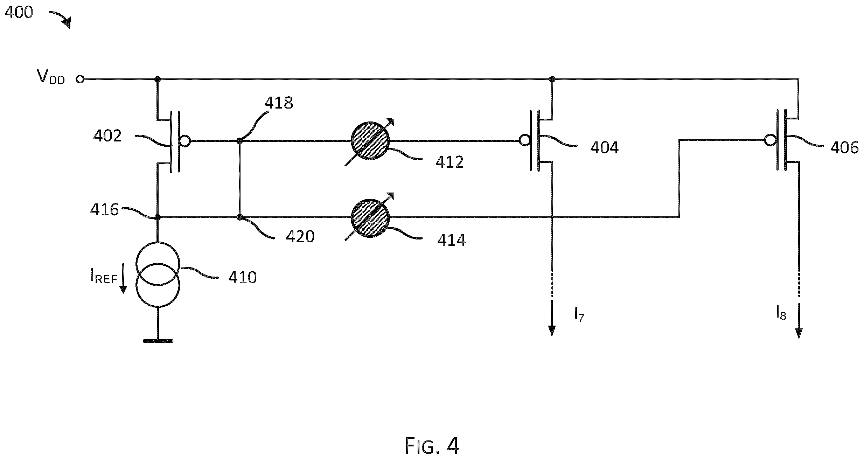

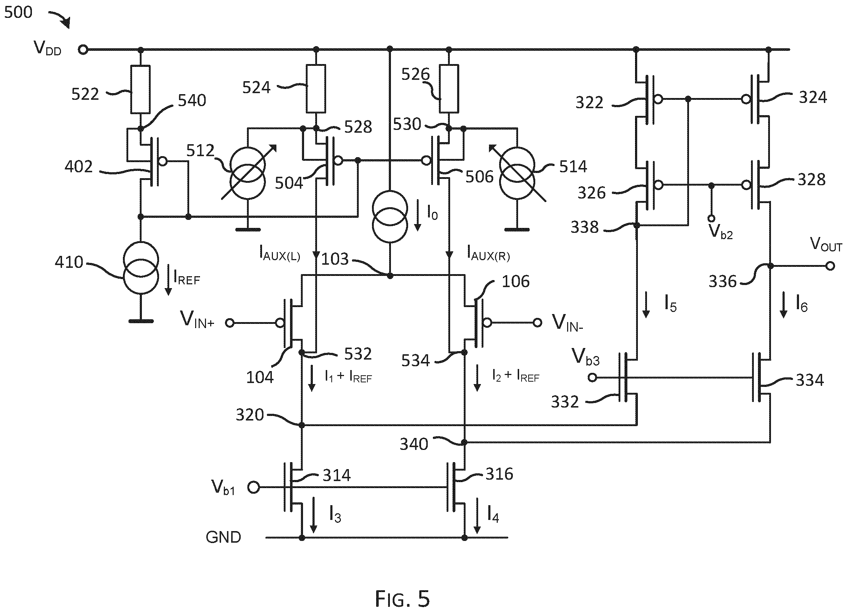

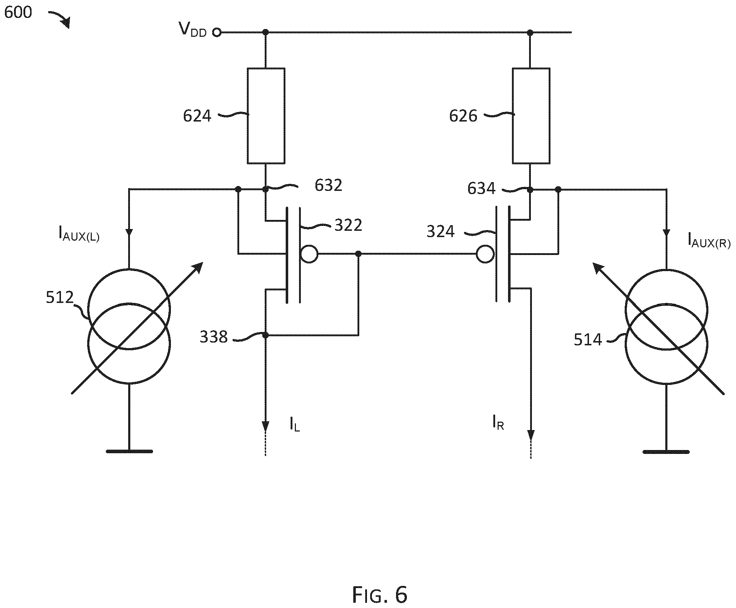

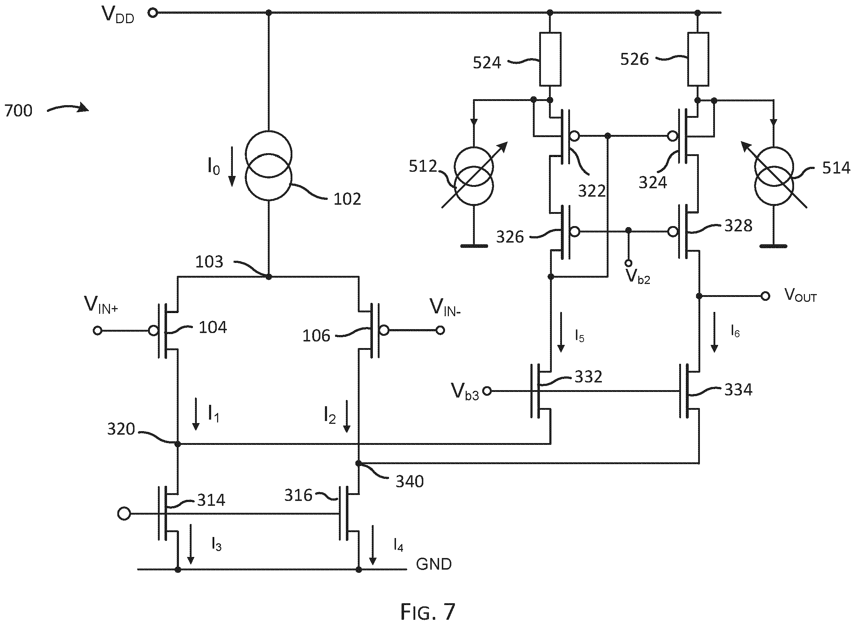

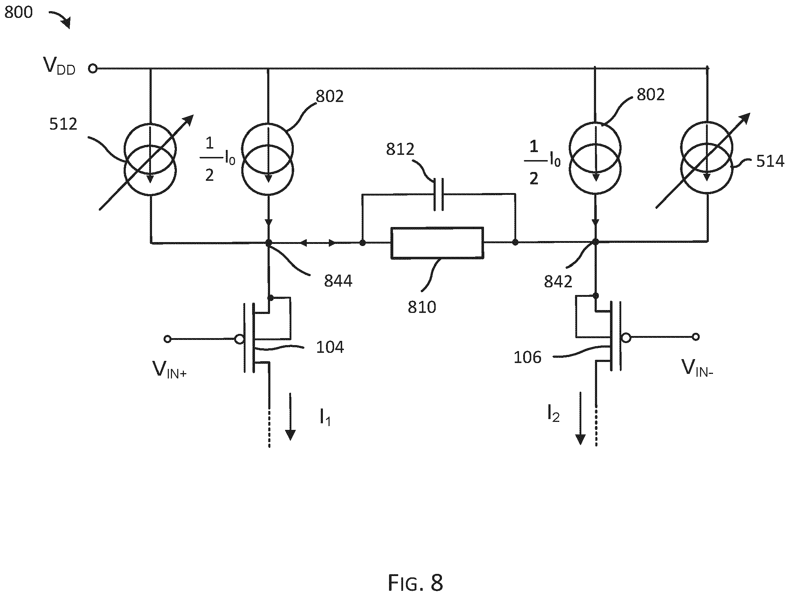

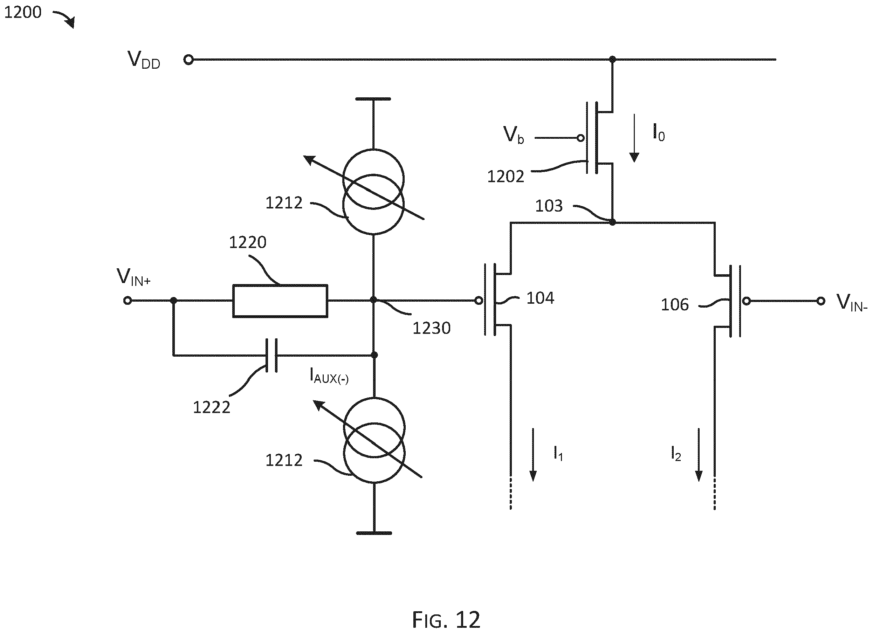

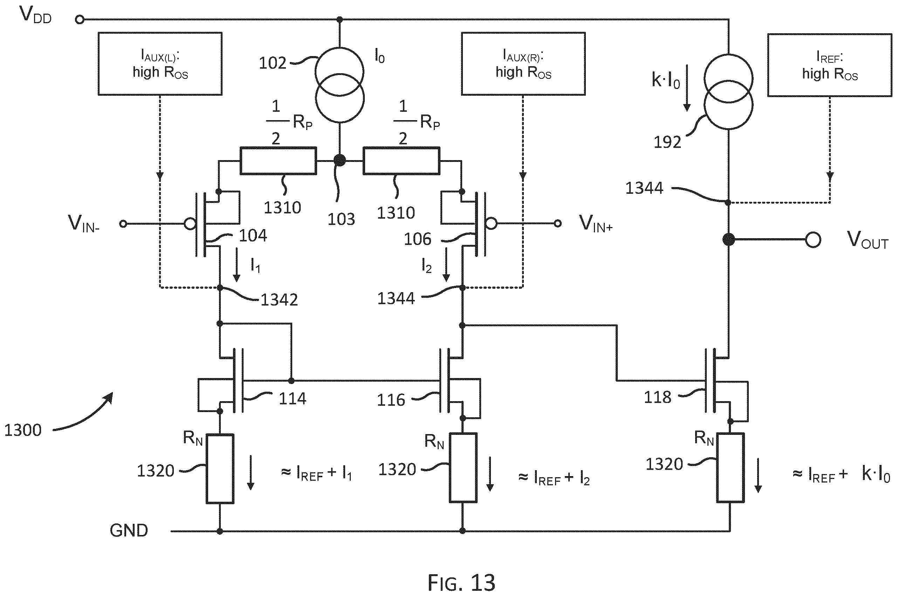

Embodiments of the disclosure are described in the context of the accompanying drawings. Embodiments of circuits including temperature compensated programmable current injection will be described using Figures 4 and 5. Embodiments of current mirror circuits with current injection will be described using Figures 6 and 7. Embodiments of tail voltage generation circuits will be described using Figures 8, 9, 10, and 11. An embodiment of a circuit for gate input offset voltage will be described using Figure 12. An embodiment of an operational transconductance amplifier configured for trimming through temperature-compensated current injections and allowing adjustment of the transconductance temperature characteristic will be described using Figure 13.

The first gain stage of a typical comparator or operational amplifier (e.g., one using CMOS devices) contains a source-coupled differential pair and one or more current mirrors that operate as an active load (see above, Figures 1-3). Ideally, when $\Delta V_{IN} = O$, the currents at the output branch are balanced. In other words, if the terminals of an OTA are short-circuited, the input differential voltage should ideally be zero and the output current should also be zero. However, there is usually an offset voltage $V_{OS}$ present from device mismatch in differential pairs or current mirrors of the active load. This device mismatch may occur due to process variations in a supposedly identical pair of devices. Under this condition, the output voltage $V_{OUT}$ is equal to about half of the supply voltage $V_{DD}$.

Input referred offset voltage $V_{OS}$ originating from the difference in threshold voltage $\Delta V_{TH(IN)}$ and the difference in gain factor $\Delta(\beta/\beta)_{IN}$ between the input transistors (e.g., transistors 104 and 106) can be expressed as Eq. (5):

$$V_{OS(IN)} = -\frac{\Delta\beta_{IN}}{\beta_{IN}}\frac{V_{GS(IN)} - V_{TH(IN)}}{2} + \Delta V_{TH(IN)} \qquad (5)$$

Large aspect ratio $(W/L)_{IN}$ in the structure of the input transistors results in relatively a low overdrive voltage Vov. In this case, the dominant component of Eq. (5) is $\Delta V_{TH(IN)}$. In the case of large $(W/L)_{IN}$ and lower differential pair bias current, the differential pair may operate in the subthreshold region. In this case, Eq. (5) may no longer be applicable. However, While the subthreshold operation can offer advantages such as improved transconductance, it may also result in a slight degradation of the temperature drift of the offset voltage $V_{OS}$.

The mismatch $\Delta V_{TH(CM)}$ and $\Delta(\beta/\beta)_{CM}$ in an active load current mirror (e.g., transistors 314 and 316; see above, Figure 3) generates offset between currents $I_1$ and $I_2$ (see above, Figure 3). The offset $\Delta I_{CM}/I_{D(0)}$ in an OTA current mirror can be written as:

$$\frac{\Delta I_{CM}}{I_{D(0)}} = \frac{\Delta\beta_{CM}}{\beta_{CM}} - \frac{2\Delta V_{TH(CM)}}{V_{GS(CM)} - V_{TH(CM)}} \qquad (6)$$

where $I_{D(0)}$ is the drain current e.g. $I_{D(o)} = 0.5 \cdot I_0$ in the example OTA. Compared to the differential pair, the current mirror may operate with high overdrive (in other words, with low $W/L$), which helps to reduce the current mirror offset $\Delta I_{CM}$. Advantageously, the folded cascode OTA 300 (see above, Figure 3) reduces $I_{D(o)}$ of the second current mirror comprising transistors 322 and 324. The current mirror offset $\Delta I_{CM}$ is referred to the input Vos as Eq. (7):

$$V_{OS} = V_{OS(IN)} + \frac{\Delta I_{CM(1)}}{g_{m(IN)}} + \frac{\Delta I_{CM(2)}}{g_{m(IN)}}... \qquad (7)$$

where $g_{m(IN)}$ represents the transconductance of the differential pair and $\Delta I_{CM(n)}$ represents the contribution of respective current mirrors in the OTA.

Eqs. (5), (6) and (7) can be rewritten to emphasize their dependence on the main bias current $I_0$. The offset voltage $V_{OS(IN)}$ of Eq. (5) originating from a differential pair in saturation can be re-written as Eq. (8):

$$V_{OS} = -\frac{\Delta\beta_{IN}}{\beta_{IN}}\frac{\sqrt{I_0}}{2\sqrt{\beta_{IN}}} + \Delta V_{TH(IN)} \qquad (8)$$

and the current offset of Eq. (6) originating from the current mirror mismatch can be rewritten as Eq. (9):

$$\Delta I_{CM} = \frac{I_0}{2}\left(\frac{\Delta\beta_{CM}}{\beta_{CM}} - \frac{2\sqrt{\beta_{CM}}}{\sqrt{I_0}} \cdot \Delta V_{TH(CM)}\right) \qquad (9)$$

The previous equations may be combined by using Eq. (7) to express the total offset voltage Vas as a function of the uncorrelated contributions of design variables gain factor $\beta$, bias current $I_o$, and matching errors $\Delta(\beta/\beta)_{IN,CMn}$ and

$\Delta V_{TH(IN,CMn)}$. This results in a general offset formula for an OTA with transistors operating in saturation shown in Eq. (10):

$$V_{OS} = \Delta V_{TH(IN)} + \frac{\sqrt{I_0}}{2\sqrt{\beta_{IN}}}\left\{\frac{\Delta \beta_{CMn}}{\beta_{CMn}} - \frac{\Delta \beta_{IN}}{\beta_{IN}}\right\} - \frac{\sqrt{\beta_{CM}I_D}}{\sqrt{\beta_{IN}I_0}}\Delta V_{TH(CMn)} \qquad (10)$$

For OTAs with some integer n of current mirrors, the factors $\Delta(\beta_{CMn}/\beta_{CMn})$ and $\Delta V_{TH(CMn)}$ should be included in Eq. (10) scaled by appropriate drain current $I_{D(0)}$. $\Delta V_{TH}$, $\Delta \beta/\beta$, and $I_0$ may be considered, to the first order, temperature and bias independent. However, the differential pair gain factor $\beta_{IN}$ and the current mirror gain factor $\beta_{CM}$ may have a strong temperature dependency. Embodiments of the disclosure include circuits and methods of operation to compensate for offset voltage $V_{OS}$ while reducing thermal drift arising from the differential pair gain factor $\beta_{IN}$ and the current mirror gain factor $\beta_{CM}$.

Generally, for low overdrive differential pairs or differential pairs operating in the subthreshold region, $\Delta V_{TH(IN)}$ is the primary factor contributing to offset voltage Vos. It represents the threshold voltage $V_{TH}$ difference between differential pair transistors (e.g., between transistors 104 and 106). Its value may depend on input transistor effective area $(W \cdot L)_{IN}$. As such, $\Delta V_{TH(IN)}$ may exhibit very good temperature stability, leading to a low thermal drift dVos/dT of an uncompensated Vos.

The mismatch factors $\Delta\beta_{IN}/\beta_{IN}$ and $\Delta\beta_{CMn}/\beta_{CMn}$ may arise from lithographic inaccuracies and carrier mobility spatial gradient. Both are weighted by the term $\sqrt{(I_{0,D(0)}/(4\beta_{IN}))}$. Their contribution to offset voltage Vos depends on the bias current $I_0$, drain current $I_{D(0)}$, temperature, the gain factor $\beta_{IN} = \mu_{n,p}C_{ox}(W/L)_{IN}$. and the respective areas of the input differential pair transistors and current mirror transistors. In the cases of low overdrive differential pairs and high overdrive current mirrors, the overall contribution is generally low and may be considered negligible.

The contribution of $\Delta V_{TH(CMn)}$ is comparable to $\Delta V_{TH(IN)}$ and is reduced by the transconductance ratio $g_{m(CMn)}/g_{m(IN)}$. This ratio represents the voltage gain between the gates of a current mirror n and the input terminals.

As such, the overall contribution of all $\Delta V_{TH(CMn)}$ may be lower than $\Delta V_{TH(IN)}$. The dependency of $g_{m(CM)}$ on $\sqrt{\mu_{n,p}}$ may

reduce or eliminate the temperature contribution of $\sqrt{\beta_{CM}/\beta_{IN}}$ when the channel doping polarity of the differential pair and the current mirror n are identical. In such cases, $\Delta V_{TH(CMn)}$ contributes to $V_{OS}$ with a very low temperature drift, similar to the very low thermal drift contribution of $\Delta V_{TH(IN)}$.

Injecting a programmable current $I_{AUX}$ into respective terminals (e.g., drain terminals) of the differential pair (e.g., the transistors 104 and 106) allows for the cancellation of the offset voltage Vos so that equilibrium is reached (with output voltage at about half of the supply voltage $V_{DD}$) for zero input voltage ($\Delta V_{IN} = O$). In some embodiments, adjustable current sources are implemented as a current steering digital to analog converter (DAC) with discrete steps. The value of the discrete step is determined by the offset trimming step and may be very small, such as in the nA range. The programmable current sources may be implemented either as a bipolar current source (in other words, a single source delivering positive or negative current) as two unipolar current sources, such as a left (L) source and a right (R) source. In the two unipolar current source configuration, each source may compensate for a respective polarity of offset voltage Vas. In other words, one current source compensates for positive offset voltage Vas and the other current source compensates for negative offset voltage Vos.

An offset voltage $V_{OS(IAUX)}$ generated by the injected programmable current $I_{AUX}$ appears between the input voltage terminals $V_{IN+}$ and $V_{IN-}$ as shown in Eq. (11):

$$V_{OS(IAUX)} = \frac{\pm I_{AUX}}{g_{m(IN)}} \qquad (11)$$

where $g_{m(IN)}$ is the differential pair transconductance:

$$g_{m(IN)} = \sqrt{2\mu_{n,p}Cox\frac{W}{L}I_D} = \sqrt{2\beta I_D} \qquad (12)$$

Compensation of the offset voltage is achieved for $V_{OS(IAUX)} = -V_{OS}$. Although the offset voltage may be primarily determined by the thermally stable $\Delta V_{TH(IN)}$, the differential pair transconductance $g_{m(IN)}$ contains a temperature dependent term of the carrier mobility $\mu_{n,p}(T)$. As such, the compensatory offset voltage $V_{OS(IAUX)}$ of Eq. (11) may have a high temperature drift. As a result, compensating for the relatively thermally stable offset voltage $\Delta V_{TH(IN)}$ through the thermally unstable transconductance $g_{m(IN)}$ may leads to a significantly higher thermal drift dVos/dT compared to the initial uncompensated offset voltage Vos.

Providing a programmable current $I_{AUX(L,R)}(T)$ with an appropriate thermal function may reduce or eliminate the temperature drift of the compensation described above with respect to Eq. (12). A. Resulting from Eq. (11), the preferred temperature characteristic of the programmable current $I_{AUX(L,R)}(T)$ maybe identical to the input differential pair transconductance $g_{m(IN)}$ (see above, Eq. (12)). Such compensating programmable current $I_{AUX(L,R)}(T)$ therefore generates a temperature-stable input offset $V_{OS(AUX)}$ which can effectively compensate the terms in Eq. (10) that are either temperature-stable or weakly temperature dependent (e.g., terms attenuated by a high $g_{m(CM)}/g_{m(IN)}$ ratio).

Figures 4 and 5 illustrate schematics of circuits including temperature compensated programmable current generator(s) provided by a supplementary current mirror. Figure 4 illustrates a schematic of a current source 400 providing a current with a desired compensating thermal dependence to match a thermal dependence of an OTA input differential pair, in accordance with some embodiments. The current source 400 comprises a reference transistor 402, source transistors 404 and 406, a reference current source $I_{REF}$, and auxiliary offset voltage sources 412 and 414. In some embodiments, the reference transistor 402 and source transistors 404 and 406 are PMOS devices. However, any suitable transistors may be used. The polarity of the temperature compensated current generator transistor is desirably to be identical to the channel polarity of the differential pair.

The reference current source 410 provides a reference current $I_{REF}$, which may be about 0.1 of the bias current $I_0$. The reference current source 410 is coupled between a ground node and node 416. The reference transistor 402 is couple by its terminals between a supply voltage node providing supply voltage $V_{DD}$ and node 416. The source transistors 404 and 406 are coupled by respective terminals to the supply voltage node. The auxiliary offset voltage source 412 is coupled to the gate of the reference transistor 402 through node 418 and to the gate of the source transistor 404. The auxiliary offset voltage source 414 is coupled to the gate of the reference transistor 402 through nodes 420 and node 418, to the reference current source 410 through the nodes 420 and 416, and to the gate of the source transistor 406. Node 420 is coupled to nodes 416 and 418. Temperature-dependent currents $I_{s(L)}$ and $I_{s(R)}$ flow from terminals of the source transistors 404 and 406 opposite the supply voltage node.

In some embodiments, the reference transistor 402 and source transistors 404 and 406 form a supplementary current mirror which contains an auxiliary offset voltage $V_{OS(CM)}$ that is applied between the respective gates of the reference transistor 402 and source transistors 404 and 406. In other embodiments, the described supplementary current mirror is implemented in a cascoded variant. The drain current $I_{s(L)}$ of the source transistor 404 and the drain current $I_{s(R)}$ of the source transistor 406 (equivalent to source transistors 504 and 506 in Figure 5 below) will experience shifts with respect to the reference current $I_{REF}$ denoted as auxiliary currents $I_{AUX(L)}(T) = I_{REF} - I_{S(L)}(T)$ and $I_{AUX(R)}(T) = I_{REF} - I_{S(R)}(T)$. The offset current $I_{OS}$ produced by the current source 400 and used to provide temperature stable compensation of the OTA is the difference of the auxiliary currents $I_{OS} = I_{AUX(L)}(T) - I_{AUX(R)}(T)$.

The shift in $I_{OS}$ for a given temperature can be determined using the drain current formula (see above, Eq. (1)). $I_{REF}$ can be written as:

$$I_{\text{REF}} = \frac{\mu_{n,p} C_{ox}}{2} \left(\frac{W}{L}\right) \left(V_{GS(R)} - V_{TH}\right)^2 \qquad (13)$$

where W/L refers to the aspect ratio of the transistors 402, 404 and 406. For a given reference current $I_{REF}$, the gate source voltage $V_{GS(R)}$ of the reference transistor 402 can be isolated from Eq. (13) as Eq. (16):

$$V_{GS(R)} = V_{TH} + \sqrt{\frac{2 I_{\text{REF}}}{\mu_{n,p} C_{ox}} \left(\frac{L}{W}\right)} \qquad (14)$$

The drain current $I_S$ of each source transistor 404 and 406 results from $V_{GS(R)} + V_{OS(CM)}$:

$$I_S = \frac{\mu_{n,p} C_{ox}}{2} \left(\frac{W}{L}\right) \left(V_{GS(R)} + V_{OS(CM)} - V_{TH}\right)^2 \qquad (15)$$

Combining Eqs. (14) and (15) and subtracting the result from the reference current $I_{REF}$ yields the current difference $I_{OS} = I_{REF} - I_S$:

$$I_{OS} = V_{OS(CM)} \sqrt{\mu_{n,p} C_{ox} I_{REF} \left(\frac{W}{L}\right)} - V_{OS(CM)}^2 \mu_{n,p} C_{ox} I_{REF} \left(\frac{W}{L}\right) \qquad (16)$$

The term $V_{OS(CM)}^2$ of Eq. (16) can be neglected. The remaining first term in Eq. (16) is comparable to the input differential transconductance $g_{m(IN)}$ (see above, Eq. (12)). By injecting the offset current $I_{OS}$ into drain terminals of a differential pair (e.g., the transistors 104 and 106; see above, Figures 1-3), an input offset voltage $V_{OS(AUX)}$ is induced between the input voltage terminals $V_{IN+}$ and $V_{IN-}$. This offset voltage arises from $I_{OS}/g_{m(IN)}$ and can be expressed from Eqs. (12) and (16) as:

$$V_{OS(AUX)} = V_{OS(CM)} \sqrt{\frac{(\mu_{n,p} C_{ox} I_{REF})_{CM} \left(\frac{W}{L}\right)_{CM}}{(\mu_{n,p} C_{ox} I_0)_{IN} \left(\frac{W}{L}\right)_{IN}}} \qquad (17)$$

In this equation, $W/L$, $C_{OX}$, $I_{REF}$ and $I_0$ are constant terms with no temperature contribution. When considering the identical channel polarity of the differential pair and current source 400, the nominator and denominator terms $\mu_{n,p}$ cancel each other. In this case, Eq. (19) can be simplified to:

$$V_{OS(AUX)} = V_{OS(CM)} \alpha \sqrt{\frac{\left(\frac{W}{L}\right)_{CM}}{\left(\frac{W}{L}\right)_{IN}}} \qquad (18)$$

where $\alpha$ represents constant terms in Eq. (17). In addition to providing compensation of the difference in input differential pair threshold voltage $\Delta V_{TH(IN)}$, $I_{OS}$ provides temperature stable compensation for the $\Delta V_{TH(CM5,6)}$ term of Eq. (10) when referring to the folded cascode OTA 500 of Figure 5 below. This is because the current mirror transistors 322 and 324 have the same channel polarity as the input differential pair transistors 104 and 106 and the reference transistor 402 and source transistors 404 and 406 (or the source transistors 504 and 506 of Figure 5 below).

Figure 5 illustrates a schematic of a folded cascode OTA 500 with current injection from a temperature compensated current source, in accordance with some embodiments. The folded cascode OTA 500 includes a current source (also referred to as a current injection circuit) providing a current with a compensating thermal dependence to match a thermal dependence of the OTA input differential pair transconductance (e.g., a current source similar to current source 400; see above, Figure 4). This is implemented using the example folded cascode OTA 300 (see above, Figure 3), and the details are not repeated herein. However, embodiments of current sources providing currents with a compensating thermal dependence may be implemented in any suitable OTA or comparator circuits, including but not limited to the examples of Figures 1 and 2, and all such combinations are within the scope of the disclosed embodiments.

In the folded cascode OTA 500, a terminal of a reference transistor 402 is coupled to a supply voltage node across a source resistance 522 and terminals of source transistors 504 and 506 are coupled to the supply voltage node across respective source resistances 524 and 526, respectively. The source transistors 504 and 506 are equivalent to the source transistors 404 and 406 of current source 400 (see above, Figure 4), respectively. The source transistors 504 and 506 can also be cascoded. A reference current source 410 is coupled to a terminal of the reference transistor 402 opposite the source resistance 522 and to respective gates of the reference transistor 402 and the source transistors 504 and 506. A programmable current source 512 is coupled to a node 528 between the source resistance 524 and the source transistor 504, and a programmable current source 514 is coupled to a node 530 between the source resistance 526 and the source transistor 506. In some embodiments, the programmable current sources 512 and 514 are unipolar current sources.

In some embodiments, respective bases (also referred to as bulk terminals) of the source transistors 504 and 506 are coupled to the nodes 528 and 530, respectively, and the base of the reference transistor 402 is coupled to a node 540 between the source resistance 522 and the reference transistor 402. Electrically coupling transistor bases or bulks to terminals (e.g., to sources of the respective transistors) may be advantageous by reducing or eliminating a substrate effect of the transistors, in order to preserve desired temperature characteristic. Bulk-source couplings may be included for any transistors of the disclosed embodiments.

Terminals of the source transistors 504 and 506 opposite the source resistances 524 and 526 are coupled to nodes 532 and 534, respectively, to provide offset current injection between the differential pair and active load.

The implementation of auxiliary offset voltage sources 412 and 414 (see above, Figure 4) between the respective gates of the supplementary current mirror gates may implemented with a significant number of additional biasing circuits. As another way of implementing the concept of Figure 4, the folded cascode OTA 500 of Figure 5 introduces a supplementary current mirror comprising the reference transistor 402 and source transistors 504 and 506 with additional source resistances $R_{OS}$ (across the respective source resistances 522, 524, and 526) and programmable current sources 512 and 514. In some embodiments, the programmable current sources 512 and 514 are unipolar current steering DACs. These current sources adjust the voltages $V_{AUX(L,R)}$ across the source resistances 524 and 526 given by the product $R_{OS}I_{REF}$ for zero current produced by the programmable current sources 512 and 514 (e.g., DACs). For unipolar current sources, the voltage $V_{AUX(L,R)}$ may be adjusted on either the left or right $R_{OS}$, depending on the initial polarity of the offset voltage Vos. In this configuration, the value of the offset current $I_{OS}$ is determined by the difference $I_{AUX(L)} - I_{AUX(R)}$. To provide efficient temperature compensation of the offset voltage, the voltage on $V_{AUX(L,R)}$ generated by the static current and the programmable current sources 512 and 514 (e.g., DACs) should be temperature stable.

Figures 6 and 7 illustrate schematics of circuits including adjustment through active load current mirrors. Compensated offset voltage with low temperature drift $dV_{OS}/dT$ can be provided by adjusting an offset voltage $V_{OS(CM)}$ between gates of a current mirror, such as current mirror with the same channel doping polarity as the differential pair transistors 104 and 106.

Figure 6 illustrates a schematic of a current mirror circuit 600 comprising transistors 322 and 324 with current injection to adjust offset voltage. The current mirror circuit 600 (also referred to as a current injection circuit) may be part of a larger circuit such as an OTA or a comparator. In some embodiments, the current mirror circuit is part of a folded cascode OTA similar to the example folded cascode OTA 300 (see above, Figure 3). In the current mirror circuit 600, the transistors 322 and 324 are coupled to a supply voltage node across respective source resistances 624 and 626. A node 338 is coupled to respective gates of the transistors 322 and 324 and to a terminal of the transistor 322 opposite the source resistance 624.

A programmable current source 512 is coupled to a node 632 between the source resistance 624 and the transistor 322, and a programmable current source 514 is coupled to a node 634 between the source resistance 626 and the transistor 324. The programmable current sources 512 and 514 provide respective injected currents $I_{AUX(L)}$ and $I_{AUX(L)}$. In some embodiments, the programmable current sources 512 and 514 are unipolar current sources. In some embodiments, respective bases (also referred to as bulk terminals) of the transistors 322 and 324 are coupled to the nodes 632 and 634, respectively. Electrically coupling transistor bases or bulks to terminals (e.g., to sources of the transistors) may be advantageous by reducing or eliminating a substrate effect of the transistors.

An offset voltage $V_{OS(CM)}$ across the first current mirror comprising transistors 322 and 324 results from the difference between voltage drops $V_{AUX(L)}$ and $V_{AUX(R)}$ across the left and right source resistances 624 and 626: $V_{OS(CM)} = V_{AUX(L)} - V_{AUX(R)}$. For the case when the injected currents $I_{DAC(L,R)} = o$, the voltage drops $V_{AUX(L,R)}$ are determined by the DC bias currents of the first current mirror comprising transistors 322 and 324, and so $V_{AUX(L)}$ and $V_{AUX(R)}$ are equals. Currents $I_L$ and $I_R$ flow from the terminals of transistors 322 and 324 opposite the source resistances 624 and 626 (e.g., drain terminals of the transistors 322 and 324). The mathematical formulation and the resulting temperature characteristics of $I_{OS} = I_L - I_R$ are equivalent to the method of thermally compensated current injection described above with respect to Figures 4-5. As such, the current mirror circuit 600 provides compensated offset voltage with low temperature drift $dV_{OS}/dT$ through the active load current mirror comprising transistors 322 and 324.

Figure 7 illustrates a schematic of a folded cascode OTA 700 with current injection to adjust offset voltage of active load current mirror(s) from a temperature compensated current source, in accordance with some embodiments. The folded cascode OTA 700 includes a current mirror circuit providing an offset voltage with a compensating thermal dependence to match a thermal dependence of the OTA differential pair similar to the example current mirror circuit 600 (see above, Figure 6) implemented using the example folded cascode OTA 300 (see above, Figure 3), and the details are not repeated herein. However, embodiments of current mirror circuit providing offset voltages with a compensating thermal dependence may be implemented in any suitable OTA or comparator circuits, including but not limited to the examples of Figures 1 and 2, and all such combinations are within the scope of the disclosed embodiments. The compensation of the thermal dependency is achieved by applying the trimming (in other words, the programmable currents) to a current mirror comprising transistors 322 and 324 with identical polarity as the input differential pair (e.g., transistors 104 and 106). To provide efficient temperature compensation of the offset voltage, the voltage across the source resistances 524 and 526 generated by the static current and the programmable current sources 512 and 514 (e.g., DACs) is desirably temperature stable.

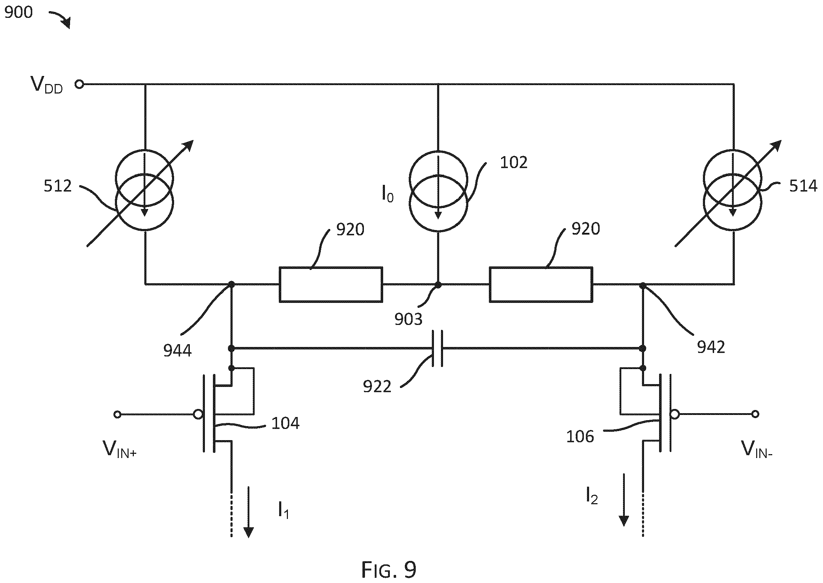

Figures 8, 9, 10, and 11 illustrate schematics of circuits including tail offset voltage trimming. Tail offset voltage trimming can be achieved with circuits comprising a single source resistance or two source resistances between terminals (e.g., source terminals) of the differential pair transistors (e.g., transistors 104 and 106). In the embodiment illustrated by Figure 8, the bias current $I_0$ is split into two current sources that each provide ½ $I_0$, and two programmable currents $I_{AUX(L,R)}$ are added to the terminals of the input differential pair transistors. In the embodiment illustrated by Figure 9, both programmable currents $I_{AUX(L,R)}$ are coupled to the terminals of the differential pair transistors (e.g., transistors 104 and 106) but only a single bias current $I_0$ is present. Tail offset voltage trimming as illustrated by Figures 8-11 provides the advantage of constant transconductance $g_{m(IN)}$ for the entire offset trimming range. A difference between the currents $I_{AUX(L)}$ - $I_{AUX(R)}$ creates an voltage drop between the sources of the differential pair. This voltage drop induce an offset between the input terminals that compensates for the initial offset voltage. To provide efficient temperature compensation of the offset voltage, the voltage across the source resistance(s) Ros of the differential pair transistors generated by the static current and the programmable currents $I_{AUX(L,R)}$ (e.g., by DACs) is desirably temperature stable.

Figure 8 illustrates a schematic of a circuit 800 with tail offset voltage trimming and two bias current sources, in accordance with some embodiments. Circuit 800 includes a differential pair comprising transistors 104 and 106, in accordance with some embodiments. The differential pair may be part of a circuit such as an OTA or comparator (e.g., an OTA illustrated by Figures 1, 2, or 3). However, the differential pair may be part of any suitable circuit. The differential pair can be implemented by NMOS and/or PMOS devices. A respective terminal of the transistor 106 is coupled to a bias current source 802 through a node 842, and a respective terminal of the transistor 104 is coupled to a bias current source 802 through a node 844. The bias current sources 802 each provide ½ $I_0$ of a bias current $I_0$ to the differential pair. The nodes 842 and 844 are coupled to each other through a source resistance 810. In some embodiments, a capacitor 812 is coupled between the nodes 842 and 844 in parallel with the source resistance 810. This may be advantageous for improving the differential pair input transconductance $g_{m(IN)}$.

A programmable current source 512 is coupled to the node 844 and a programmable current source 514 is coupled to the node 842. In some embodiments, the programmable current sources 512 and 514 are bipolar current sources to provide positive and/or negative current to one or both nodes 842 and 844 (or in Figure 9 below, nodes 942 and 944). In some embodiments, the programmable current sources 512 and 514 are unipolar and provide single polarity compensating current to one of the terminals of the transistors 104 and 106.

Figure 9 illustrates a schematic of a circuit 900 for tail offset voltage trimming with one bias current source, in accordance with some embodiments. Circuit 900 includes a differential pair comprising transistors 104 and 106, in accordance with some embodiments. The differential pair may be part of a circuit such as an OTA or comparator (e.g., an OTA illustrated by Figures 1, 2, or 3). However, the differential pair may be part of any suitable circuit. A respective terminal of the transistor 106 is coupled to a bias current source 102 through a node 942, a source resistance 920, and a node 903, and a respective terminal of the transistor 104 is coupled to the bias current source 102 through a node 944, a source resistance 920, and the node 903. The bias current sources 802 each provide ½ $I_0$ of a bias current $I_0$ to the differential pair. In some embodiments, a capacitor 922 is coupled between the nodes 942 and 944 in parallel with the source resistances 920 (coupled in series through the node 903). This may be advantageous for improving the differential pair input transconductance $g_{m(IN)}$. A programmable current source 512 is coupled to the node 944 and a programmable current source 514 is coupled to the node 942.

In some embodiments, respective bases (also referred to as bulk terminals) of the transistors 104 and 106 are coupled to the nodes 944 and 942, respectively. Electrically coupling transistor bases or bulks to terminals (e.g., to sources of the transistors 104 and 106) may be advantageous by reducing or eliminating a substrate effect of the transistors and therefore improving the thermal stability of the offset compensation.

Both the circuit 800 as illustrated by Figure 8 and the circuit 900 as illustrated by Figure 9 allow for providing temperature stable compensation of the offset voltage. This is achieved in cases when the voltage drops across the source resistances 810 and/or 920 are stable in temperature. This can be achieved, for example, by using temperature stable resistances and temperature stable current source. As the voltage present across these resistances is referred to the input, the stable voltage across the resistances 810 and 920 compensate a temperature stable offset voltage originating mainly from the difference in threshold voltage $\Delta V_{TH}$ (e.g., of the input differential transistors 104 and 106).

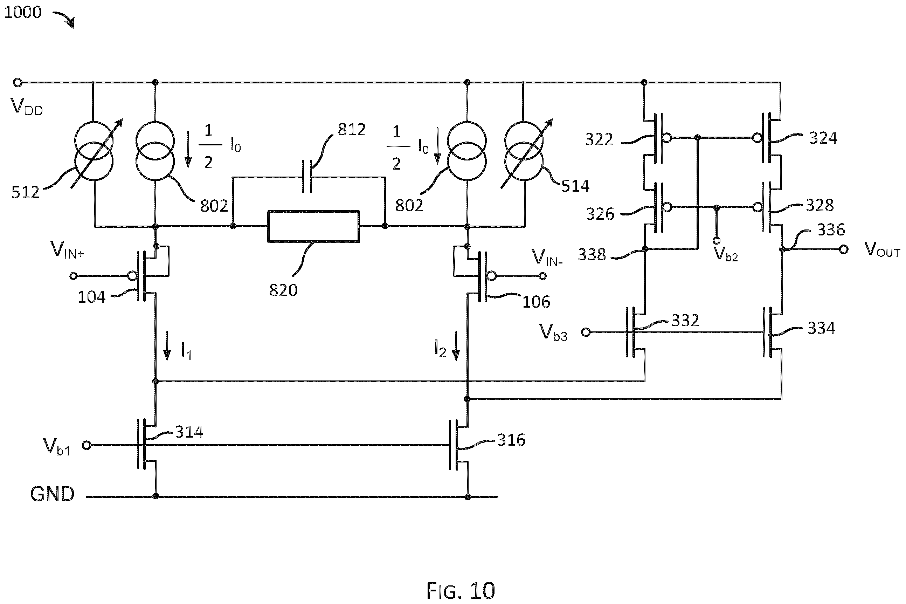

Figure 10 illustrates a schematic of a folded cascode OTA 1000 with tail offset voltage trimming, in accordance with some embodiments. The folded cascode OTA 1000 includes the circuit 800 (see above, Figure 8) using the example folded cascode OTA 300 (see above, Figure 3), and the details are not repeated herein. However, embodiments of tail voltage trimming similar to the circuit 800 may be implemented in any suitable OTA or comparator circuits, including but not limited to the examples of Figures 1 and 2 and the embodiments illustrated by Figures 5, 7, and 13, and all such combinations are within the scope of the disclosed embodiments.

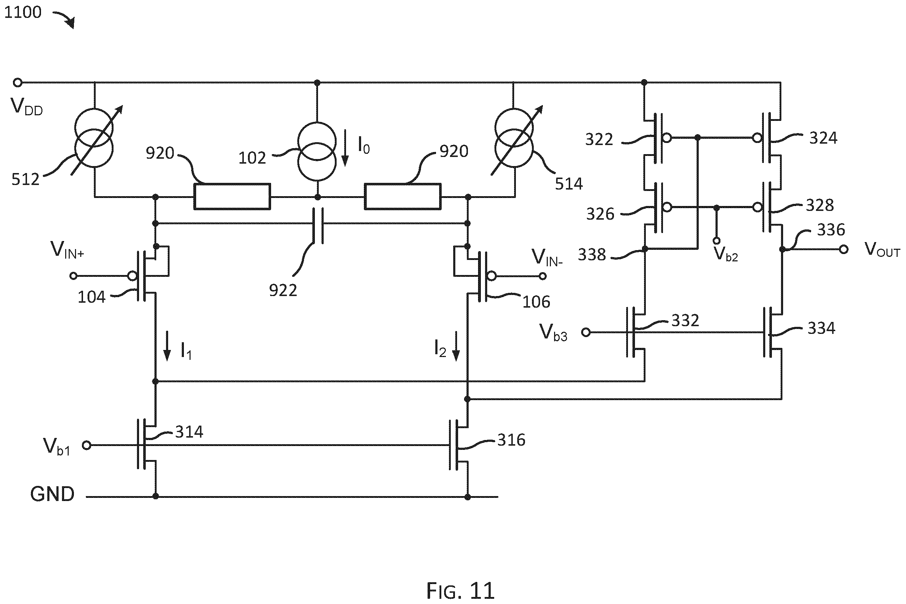

Figure 11 illustrates a schematic of a folded cascode OTA 1100 with for tail offset voltage trimming, in accordance with some embodiments. The folded cascode OTA 1000 includes the circuit 900 (see above, Figure 9) using the example folded cascode OTA 300 (see above, Figure 3), and the details are not repeated herein. However, embodiments of tail voltage trimming similar to the circuit 900 may be implemented in any suitable OTA or comparator circuits, including but not limited to the examples of Figures 1 and 2 and the embodiments illustrated by Figures 5, 7, and 13, and all such combinations are within the scope of the disclosed embodiments.

Figure 12 illustrates a schematic of a circuit 1200 for gate input offset voltage provided behind a gate of a differential pair transistor, in accordance with some embodiments. In cases where the output resistance of the voltage source is relatively small, an offset voltage $V_{AUX}$ can be generated directly between one or both gates of the input differential pair (e.g., the transistors 104 and 106) and the input voltage terminal.

A bias current source 1202 is coupled to a supply voltage node providing a supply voltage $V_{DD}$ and to a node 103. In some embodiments, the bias current source 1202 is a PMOS device coupled to a bias voltage $V_b$ at its gate. However, any suitable current source may be used for the bias current source 102. The bias current source 1202 may be coupled to the supply voltage node at supply voltage $V_{DD}$ at its source terminal and to the node 103 at its drain terminal. The bias current source 102 may also be coupled to the supply voltage node at its drain terminal and to the node 103 at its source terminal.

Transistors 104 and 106 form a differential pair (also referred to as a long-tailed pair). Terminals of the transistors 104 and 106 are coupled to node 103, which receives a bias current $I_0$ from the bias current source 1202 and is at a tail voltage $V_{TAIL}$. Terminals provided with respective input voltages $V_{IN+}$ and $V_{IN-}$ are coupled to the gates of the transistors 104 and 106, respectively. In some examples, the transistors 104 and 106 of the differential pair are CMOS devices. However, any suitable transistors, such as NMOS devices or the like, may be used to form the differential pair.

One or more programmable current sources 1212 inject current into the shunt resistance across the shunt resistor 1220. This generates a voltage drop $V_{AUX}$ between the gate of the transistor 104 and the voltage source. With a temperature stable shunt resistance, this trimming method provides reliable compensation for the temperature-constant terms in Eq. (10) above. The programmable current sources 1212 may be similar to the programmable current sources 512 and 514 described above with respect to Figure 5, and the details are not repeated herein.

Embodiments of the circuit 1200 for offset voltage provided behind a gate of a differential pair transistor may be implemented in any suitable OTA or comparator circuits, including but not limited to the examples of Figures 1-3 and the embodiments illustrated by Figures 5, 7, 10, 11, and 13, and all such combinations are within the scope of the disclosed embodiments.

Figure 13 illustrates a schematic of a Miller OTA 1300 configured for trimming through temperature-compensated current injections, in accordance with some embodiments. The Miller OTA 1300 is implemented using the example Miller OTA 100 (see above, Figure 1), and the details are not repeated herein. Respective resistors 1310 are coupled between the node 103 and the transistors 104 and 106. Respective resistors 1320 are coupled between respective transistors 114, 116, and output transistor 118 and the ground node. In some embodiments, respective bases (also referred to as bulk terminals) of the transistors 104, 106, 114, 116, and 118 are coupled to respective terminals (e.g., sources) of the transistors 104, 106, 114, 116, and 118. Electrically coupling transistor bases or bulks to terminals (e.g., to sources of the respective transistors) may be advantageous by reducing or eliminating a substrate effect of the transistors in order to preserve desired temperature characteristic. Bulk-source couplings may be included for any transistors of the disclosed embodiments of Figures 4-13.

Temperature-compensated offset current injection is performed similar to the configuration described above with respect to Figure 5. Left programmable current $I_{AUX(L)}$ is injected at node 1342 between transistors 104 and 114 and right programmable current IAUX(L) is injected at node 1344 between transistors 106 and 116. Reference current IREF is injected at node 1344 between the current source 192 and the output transistor 118. In the initial configuration from Figure 5, a low value of the source resistances $R_{os}$ may be desirable in order to match the offset current los(T) temperature characteristic with the temperature characteristic of the input transconductance $g_{m(IN)}$ of the differential pair. This may lead to an inconvenient or undesirable high trimming current. In order to reduce the trimming currents (e.g., the left programmable current $I_{AUX(L)}$, the right programmable current $I_{AUX(L)}$, and the reference current $I_{REF}$) a high source resistance $R_{OS}$ in a range of 1 to 10 k$\Omega$ may be used. For example, a resistance of 5 k$\Omega$ may be used for the equivalent of source resistances 522, 524, and 526 (see above, Figure 5). However, this may alter the temperature characteristic of the offset current $I_{OS}(T)$, and deteriorate the quality of the compensation based on the temperature matching of the los(T) temperature characteristic, and the differential pair temperature characteristic. This deterioration may be due to the offset current $I_{OS}(T)$ no longer being dependent only on $g_m$ but rather dependent on source resistance Ros in addition to $g_m$. Resistors 1310 with respective resistances ½ $R_P$ and resistors 1320 with resistances $R_N$ may be employed in order to align the modified characteristic of the offset current $I_{OS}(T)$ with the temperature characteristic of the differential pair and also to further improve temperature matching for an active load implemented with a different channel polarity of transistor than the differential pair (e.g., PMOS differential pair and NMOS active load or the reverse). In some embodiments, the resistance $R_P$ is in a range of 100 $\Omega$ to 10 k$\Omega$ and the resistance $R_N$ is in a range of 100 $\Omega$ to 10 k$\Omega$.

Eq. (10) above addresses the temperature-dependent term related to the gain between $\Delta V_{TH(CM)}$ and $\Delta V_{IN}$ that is related to the ratio of electron and hole mobility. Although the electron and hole mobility results from different scattering mechanisms, their temperature dependencies may be similar but not exactly equal for a given process. In certain cases, the mutual ratio of the transconductances can exhibit a noticeable temperature drift. For instance, this may occur when different types of devices are used within the OTA, when the differential pair operates in the subthreshold region where the

transconductance differs from Eq. (3), or when the resulting transconductance is affected by a high channel length modulation effect. In such scenarios, the last term in Eq. (10) can introduce significant (residual) temperature instability resulting in a higher voltage drift of the compensated or uncompensated offset voltage Vos.

In some embodiments, the temperature stability of the transconductance ratio $g_{m(CMn)}/g_{m(IN)}$ is improved by selectively applying temperature transconductance damping to either the PMOS or NMOS transistor in an OTA. This temperature dumping is achieved by using resistors 1310 with total resistance $R_P$ and resistors 1320 with respective resistances $R_N$ (see above, Figure 13). These resistors modify the temperature behavior of the current mirror or of the differential pair transconductances. The effectiveness of the improvement depends on the process parameters and on the OTA DC operating point. Incorporation of the temperature damping can improve resulting trimming performance and also effectively reduce the temperature drift exhibited by the uncompensated OTA. This may be advantageous for systems where the offset of the signal processing chain is trimmed externally, such as by the reference voltage source. It can also improve matching with offset current $I_{os}(T)$ that is deteriorated by large source resistance Ros. These resistances $R_N$ and $R_P$ are used to adjust the temperature characteristic of the differential pair and current mirror transistor and not to improve, for example, linearity or matching of the circuit by functioning as degeneration resistances.

The temperature transconductance damping may be performed using the adjustment achieved by an additional element with distinct temperature characteristics compared to a MOS transistor. For example, this element can be a temperature-stable resistance coupled to the source of a MOS transistor. As a consequence, the resulting transconductance is proportionally dependent on the temperature characteristic of both the MOS transistor and. For example, temperature-stable resistance. As an example, differential pairs (e.g., transistors 104 and 106, see above, Figures 8-11 and Figure 13) have a source resistance $R_{OS}$ that modifies the temperature slope of $g_{m(IN)}(T)$. The modified (in other words, degenerated) transconductance of the differential pair resulting from the presence of Ros can be described by following equation:

$$g_{m(IN)}(T) = \frac{g_{m1,2}(T)}{g_{m1,2}(T)R_{OS}+1} \qquad (19)$$

where $g_{m1,2}$ refers to transistors 104 and 106. Similarly, temperature behavior of the active load current mirror $g_{m(CM)}(T)$ can also be adjusted by additional serial source resistance.

Example embodiments of the disclosure are summarized here. Other embodiments can also be understood from the entirety of the specification as well as the claims filed herein.

Example 1. A circuit including: a current source; a differential pair of transistors coupled to the current source, the differential pair of transistors having a first offset voltage and an input transconductance; an active load, the active load being coupled to respective drains of the differential pair of transistors opposite the current source; and a current injection circuit, the current injection circuit being coupled to the respective drains of the differential pair of transistors, the current injection circuit being configured to supply a first current and a second current to the respective drains, the first current and the second current producing a second offset voltage across the differential pair of transistors opposite the first offset voltage, the first current and the second current having a same thermal dependence as the input transconductance of the differential pair of transistors.

Example 2. The circuit of example 1, where the differential pair of transistors are PMOS devices.

Example 3. The circuit of one of examples 1 or 2, where the active load includes a first current mirror, the first current mirror including NMOS devices.

Example 4. The circuit of one of examples 1 to 3, where the current injection circuit includes a supplementary current mirror.

Example 5. The circuit of one of examples 1 to 4, where a bulk of a transistor of the supplementary current mirror is coupled to a source of the transistor of the supplementary current mirror.

Example 6. The circuit of one of examples 1 to 5, where the current injection circuit further includes a programmable current source.

Example 7. The circuit of example 6, where the programmable current source is a current steering digital to analog converter.

Example 8. A circuit including: a current source, the current source being coupled to a supply voltage node; a differential pair of transistors coupled to the current source opposite the supply voltage node, the differential pair of transistors having a first offset voltage and an input transconductance, the input transconductance having a thermal dependence; an active load, the active load being coupled to the differential pair of transistors opposite the current source, the active load including a first current mirror, each transistor of the first current mirror being coupled to the supply voltage node across a respective source resistance, each transistor of the first current mirror being further coupled to respective unipolar current sources, where the respective unipolar current sources are configured to produce a first current and a second current; and a current injection circuit, the current injection circuit being coupled to respective nodes between drains of the differential pair of transistors and the active load, the current injection circuit being configured to supply a first current and a second current to the respective nodes between the drains of the differential pair of transistors and the active load, the first current and the second current producing a second offset voltage across the differential pair of transistors opposite the first offset voltage, the first current and the second current having a same thermal dependence as the input transconductance of the differential pair of transistors.

Example 9. The circuit of example 8, where the differential pair of transistors has a first polarity and the first current mirror has a second polarity, the second polarity being the same as the first polarity.

Example 10. The circuit of one of examples 8 or 9, where a respective bulk of each transistor of the first current mirror is coupled to a respective source of each transistor of the first current mirror.

Example 11. The circuit of one of examples 8 to 10, further including a programmable current source coupled to a first node, the first node being between a gate of a first transistor of the differential pair of transistors and an input voltage node.

Example 12. The circuit of example 11, further including a resistor and a capacitor coupled in parallel between the first node and the input voltage node.

Example 13. The circuit of one of examples 8 to 12, where the circuit includes a folded cascode.

Example 14. A circuit including: a differential pair, the differential pair including a first transistor and a second transistor, the first transistor and the second transistor being coupled through a first resistance; a first programmable current source coupled to a first node between the first transistor and the first resistance; a second programmable current source coupled to a second node between the second transistor and the first resistance; and a first bias current source coupled to the differential pair.

Example 15. The circuit of example 14, further including a second bias current source coupled to the second node.

Example 16. The circuit of example 15, where the first bias current source is coupled to the first node.

Example 17. The circuit of example 14, further including a second resistance being coupled between the first transistor and the second transistor in series with the first resistance, a third node being between the first resistance and the second resistance.

Example 18. The circuit of example 17, where the first bias current source is coupled to the third node.

Example 19. The circuit of one of examples 14 to 18, further including a capacitor coupled between the first transistor and the second transistor, the capacitor being in parallel with the first resistance.

Example 20. The circuit of one of examples 14 to 19, where a bulk of the first transistor is coupled to a source of the first transistor.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

**Claims**

1.  A circuit comprising:

    a current source;
    a differential pair of transistors coupled to the current source, the differential pair of transistors having a first offset voltage and an input transconductance;
    an active load, the active load being coupled to respective drains of the differential pair of transistors opposite the current source; and
    a current injection circuit, the current injection circuit being coupled to the respective drains of the differential pair of transistors, the current injection circuit being configured to supply a first current and a second current to the respective drains, the first current and the second current producing a second offset voltage across the differential pair of transistors opposite the first offset voltage, the first current and the second current having a same thermal dependence as the input transconductance of the differential pair of transistors.

2.  The circuit of claim 1, wherein the differential pair of transistors are PMOS devices.

3.  The circuit of claim 1, wherein the active load comprises a first current mirror, the first current mirror comprising NMOS devices.

4.  The circuit of claim 1, wherein the current injection circuit comprises a supplementary current mirror.

5. The circuit of claim 4, wherein a bulk of a transistor of the supplementary current mirror is coupled to a source of the transistor of the supplementary current mirror.

6. The circuit of claim 4, wherein the current injection circuit further comprises a programmable current source.

7. The circuit of claim 6, wherein the programmable current source is a current steering digital to analog converter.

8. A circuit comprising:

a current source, the current source being coupled to a supply voltage node;
a differential pair of transistors coupled to the current source opposite the supply voltage node, the differential pair of transistors having a first offset voltage and an input transconductance, the input transconductance having a thermal dependence;
an active load, the active load being coupled to the differential pair of transistors opposite the current source, the active load comprising a first current mirror, each transistor of the first current mirror being coupled to the supply voltage node across a respective source resistance, each transistor of the first current mirror being further coupled to respective unipolar current sources, wherein the respective unipolar current sources are configured to produce a first current and a second current; and
a current injection circuit, the current injection circuit being coupled to respective nodes between drains of the differential pair of transistors and the active load, the current injection circuit being configured to supply a first current and a second current to the respective nodes between the drains of the differential pair of transistors and the active load, the first current and the second current producing a second offset voltage across the differential pair of transistors opposite the first offset voltage, the first current and the second current having a same thermal dependence as the input transconductance of the differential pair of transistors.

9. The circuit of claim 8, wherein the differential pair of transistors has a first polarity and the first current mirror has a second polarity, the second polarity being the same as the first polarity.

10. The circuit of claim 8, wherein a respective bulk of each transistor of the first current mirror is coupled to a respective source of each transistor of the first current mirror.

11. The circuit of claim 8, further comprising a programmable current source coupled to a first node, the first node being between a gate of a first transistor of the differential pair of transistors and an input voltage node.

12. The circuit of claim 11, further comprising a resistor and a capacitor coupled in parallel between the first node and the input voltage node.

13. The circuit of claim 8, wherein the circuit comprises a folded cascode.

14. A circuit comprising:

a differential pair, the differential pair comprising a first transistor and a second transistor, the first transistor and the second transistor being coupled through a first resistance;
a first programmable current source coupled to a first node between the first transistor and the first resistance;
a second programmable current source coupled to a second node between the second transistor and the first resistance; and
a first bias current source coupled to the differential pair.

15. The circuit of claim 14, further comprising a second bias current source coupled to the second node.

16. The circuit of claim 15, wherein the first bias current source is coupled to the first node.

17. The circuit of claim 14, further comprising a second resistance being coupled between the first transistor and the second transistor in series with the first resistance, a third node being between the first resistance and the second resistance.

18. The circuit of claim 17, wherein the first bias current source is coupled to the third node.

19. The circuit of claim 14, further comprising a capacitor coupled between the first transistor and the second transistor, the capacitor being in parallel with the first resistance.

20. The circuit of claim 14, wherein a bulk of the first transistor is coupled to a source of the first transistor.

FIG. 1
(PRIOR ART)

EP 4 492 681 A1

FIG. 2
(PRIOR ART)

EP 4 492 681 A1

FIG. 3
(PRIOR ART)

EP 4 492 681 A1

FIG. 4

FIG. 5

EP 4 492 681 A1

FIG. 6

FIG. 7

FIG. 8

FIG. 9

FIG. 10

FIG. 11

FIG. 12

EP 4 492 681 A1

FIG. 13

Europäisches
Patentamt

European
Patent Office

Office européen
des brevets

# EUROPEAN SEARCH REPORT

**Application Number**

EP 24 18 5769

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/108936 A1 (FOREJT BRETT E [US]) 30 April 2009 (2009-04-30) * paragraph [0035] - paragraph [0044]; figures 4,5 * | 1-7 | INV. H03F1/22 H03F3/45 |
| X | US 2020/136577 A1 (IVANOV VADIM VALERIEVICH [US] ET AL) 30 April 2020 (2020-04-30) * paragraph [0027] - paragraph [0032]; figures 4-6 * | 1-13 | |
| X | US 2023/155553 A1 (AGARWAL NITIN [IN] ET AL) 18 May 2023 (2023-05-18) * paragraph [0014] - paragraph [0039]; figures 1-4 * | 1-7 | |
| X | US 8 335 249 B1 (SU XIAOYAN [US] ET AL) 18 December 2012 (2012-12-18) * column 6, line 22 - column 7, line 3; figures 6,7 * | 14-20 | |
| X | US 7 724 079 B1 (SHUMARAYEV SERGEY YURYEVICH [US]) 25 May 2010 (2010-05-25) * column 3, line 21 - column 7, line 2; figures 1-5 * | 14-20 | TECHNICAL FIELDS SEARCHED (IPC) H03F |
| A | Allen P. E.: "Lecture 19 - Differential amplifier", , 1 August 2018 (2018-08-01), pages 1-34, XP093230183, Retrieved from the Internet: URL:https://aicdesign.org/wp-content/uploads/2018/08/lecture19-150211.pdf * slides 19-4 and 19-24 * | 17,18,20 | |

-/--

The present search report has been drawn up for all claims

| Place of search | Date of completion of the search | Examiner |
|---|---|---|
| The Hague | 3 December 2024 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 24 18 5769

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2007/013440 A1 (CHEN JINGHONG [US] ET AL) 18 January 2007 (2007-01-18) * the whole document * | 11,12 | |
| A | US 2020/014348 A1 (SAWAI HIDEYUKI [JP] ET AL) 9 January 2020 (2020-01-09) * the whole document * | 11,12 | |

TECHNICAL FIELDS
SEARCHED      (IPC)

The present search report has been drawn up for all claims

| Place of search | Date of completion of the search | Examiner |
|---|---|---|
| The Hague | 3 December 2024 | Wienema, David |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                                                             
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 18 5769

This annex lists the patent family members relating to the patent documents cited in the above-mentioned European search report.
The members are as contained in the European Patent Office EDP file on
The European Patent Office is in no way liable for these particulars which are merely given for the purpose of information.

03-12-2024

| Patent document cited in search report | | Publication date | Patent family member(s) | | Publication date |
|---|---|---|---|---|---|
| US 2009108936 | A1 | 30-04-2009 | NONE | | |
| US 2020136577 | A1 | 30-04-2020 | CN | 111130543 A | 08-05-2020 |
| | | | US | 2020136577 A1 | 30-04-2020 |
| | | | US | 2021067114 A1 | 04-03-2021 |
| US 2023155553 | A1 | 18-05-2023 | CN | 114747137 A | 12-07-2022 |
| | | | US | 2021167731 A1 | 03-06-2021 |
| | | | US | 2023155553 A1 | 18-05-2023 |
| | | | WO | 2021113417 A1 | 10-06-2021 |
| US 8335249 | B1 | 18-12-2012 | NONE | | |
| US 7724079 | B1 | 25-05-2010 | US | 7321259 B1 | 22-01-2008 |
| | | | US | 7724079 B1 | 25-05-2010 |
| US 2007013440 | A1 | 18-01-2007 | US | 2007013440 A1 | 18-01-2007 |
| | | | US | 2009212856 A1 | 27-08-2009 |
| US 2020014348 | A1 | 09-01-2020 | CN | 110677130 A | 10-01-2020 |
| | | | JP | 2020010088 A | 16-01-2020 |
| | | | KR | 20200004247 A | 13-01-2020 |
| | | | TW | 202007075 A | 01-02-2020 |
| | | | US | 2020014348 A1 | 09-01-2020 |

EPO FORM P0459

For more details about this annex : see Official Journal of the European Patent Office, No. 12/82